# EUROPEAN PATENT APPLICATION

(11) **EP 1 694 061 A2**
(43) Date of publication of application: **23.08.2006**
(21) Application number: 06100406.5
(22) Date of filing: 16.01.2006
(51) Int. Cl.: H04N 5/50

(54) **Television receiving tuner with reduced size and thickness**

(30) Priority: 16.02.2005 JP 2005039235
(71) Applicant: ALPS ELECTRIC CO., LTD., Ota-ku Tokyo 145 (JP)
(72) Inventor: Yamamoto, Masaki, Ohta-ku Tokyo 145 (JP)
(74) Representative: Kensett, John Hinton

(57) **Abstract**

A television receiving tuner has a multilayer wiring board that has a ground layer provided inside and outside, a tuner unit that has a semiconductor for a high frequency, such as an IC package or the like, mounted on a bottom surface (a surface facing a mother board) of the multilayer wiring board to form a circuit, a demodulating unit that has a semiconductor for an intermediate frequency mounted on a top surface of the multilayer wiring board to form a circuit, a metal shield plate that is disposed around the demodulating unit on the top surface of the multilayer wiring board, and a plurality of terminals that are arranged over an outer circumference of the bottom surface of the multilayer wiring board. The shield plate is set to have the same height as that of the demodulating unit. In the shield plate, rib-shaped convex portions are formed through concave groove portions, and the concave groove portions are soldered to the ground layer on the multilayer wiring board.

## Description

### BACKGROUND OF THE INVENTION

### 1. Field of the Invention

The present invention relates to a television receiving tuner, and more particularly, to a television receiving tuner with reduced size and thickness which can be incorporated into a small electronic apparatus, such as a cellular phone or the like.

### 2. Description of the Related Art

A television receiving tuner for receiving a television broadcast primarily has a tuner unit that has a semiconductor for a high frequency mounted on a board to form a circuit, and a demodulating unit that has a semiconductor for an intermediate frequency mounted on the board to form a circuit. In the related art, a technology is known in which the tuner unit and the demodulating unit are provided close to each other on the same board, thereby forming a compact television receiving tuner (for example, see JP-A-6-334554 (pages 3 to 4 and FIG. 1). However, when the tuner unit and the demodulating unit are provided in parallel on the same board, since a planar size of the entire television receiving tuner cannot be sufficiently reduced, it is difficult to implement a micro television receiving tuner which can be incorporate into a small electronic apparatus, such as a cellular phone or the like.

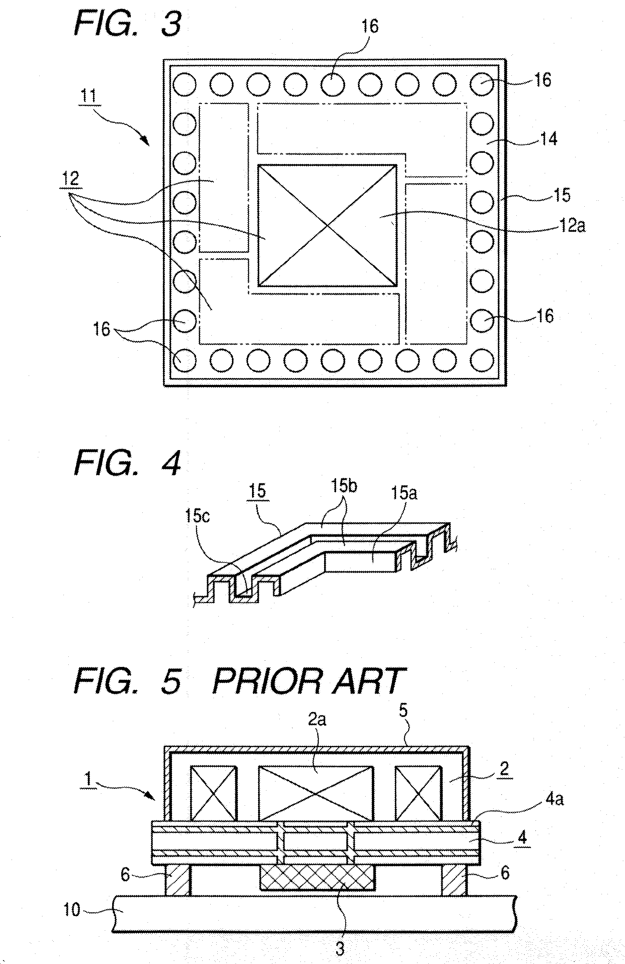

In recent years, as shown in FIG. 5, a measure for a reduction in size has been examined in which a tuner unit 2 and a demodulating unit 3 of a television receiving tuner 1 are dividedly provided on front and rear surfaces of a multilayer wiring board 4, thereby suppressing a planar size thereof. That is, the television receiving tuner 1 shown in FIG. 5 schematically has the multilayer wiring board 4 that has a ground layer 4a provided inside and outside, the tuner unit 2 that has a semiconductor for a high frequency, such as an IC package 2a or the like, mounted on a top surface of the multilayer wiring board 4 to form a circuit, a metal shield cover 5 which covers the entire tuner unit 2, the demodulating unit 3 which has a semiconductor for an intermediate frequency mounted on a bottom surface of the multilayer wiring board 4 to form a circuit, and a plurality of terminals 6 which are drawn from the tuner unit 2 or the demodulating unit 3 to the bottom surface of the multilayer wiring board 4.

The television receiving tuner 1 having the schematic configuration is mounted at a predetermined position on a mother board 10 by correspondingly soldering the terminals 6 to connection lands on the mother board 10, and thus the tuner unit 2 or the demodulating unit 3 transmits and receives electrical signals to and from an external circuit (not shown) through the individual terminals 6. Further, the tuner unit 2, which is susceptible to noise, is covered with the shield cover 5, such that noise caused by external waves does not have a bad influence on the tuner unit 2.

In the related art television receiving tuner 1 shown in FIG. 5, the planar size of the entire device can be reduced, but its height is slightly increased, and thus there is a room for improvement in view of the reduction in thickness (reduction in height). For example, it is assumed that the television receiving tuner 1 is incorporated into a recent multifunctional cellular phone with reduced size and thickness. In this case, since the planar size of the television receiving tuner 1 can be cleared, but the height thereof is excessively increased, it is practically difficult to ensure a necessary arrangement space on the mother board 1. Specifically, in the television receiving tuner 1 shown in FIG. 5, the thickness of the shield cover 5 is about 0.15 mm, a necessary clearance between the shield cover 5 and the tuner unit 2 is 0.15 mm or more, the height of the tuner unit 2 is about 0.6 mm, the thickness of the multilayer wiring board 4 is about 0.5 mm, and the height of the terminal 6 is about 0.4 mm, such that the height of the entire device is 1.8 mm or more. Accordingly, the television receiving tuner 1 having the height of 1.5 mm or less so as to be incorporated into the recent cellular phone is highly demanded.

Further, in the television receiving tuner 1 shown in FIG. 5, since the shield cover 5 covers the entire tuner unit 2, heat generated from the IC package 2a serving as a heat source cannot be efficiently emitted to the outside, and heat radiation is insufficient.

In addition, in the television receiving tuner 1 shown in FIG. 5, the numbers of electronic components provided on the front and rear surfaces of the multilayer wiring board 4 are different from each other, the surface on which the demodulating unit 3 is formed (the bottom surface) has a wide blank space where the electronic component is not mounted, as compared with the surface on which the tuner unit 2 is formed (the top surface). Therefore, the multilayer wiring board 4 may be curved, and thus reliability may be degraded.

### SUMMARY OF THE INVENTION

The invention has been finalized in view of the drawbacks inherent in the related art, and it is an object of the invention to provide a television receiving tuner which can realize a reduction in size and thickness by suppressing a planar size and a height and which has heat dissipation effect.

In order to achieve the above-described objects, a television receiving tuner according to an aspect of the invention includes a multilayer wiring board that has a ground layer provided inside and outside, a demodulating unit that has a semiconductor for an intermediate frequency mounted on a front surface of the multilayer wiring board to form a circuit, a metal shield plate that is mounted on the front surface of the multilayer wiring board so as to surround the demodulating unit and is connected to the ground layer, a tuner unit that has a semiconductor for a high frequency mounted on a rear surface of the multilayer wiring board to form a circuit, and a group of terminals that are provided in parallel over an outer circumference of the rear surface of the multilayer wiring board to be connected to a mother board. On the multilayer wiring board, a height of the shield plate is set to be substantially equal to a height of the demodulating unit, and the group of terminals is connected to the ground layer.

In the television receiving tuner having such a configuration, the tuner unit is provided on the rear surface (bottom surface) of the multilayer wiring board on the mother board, and the tuner unit is surrounded by the group of terminals. Further, the shield plate is disposed on the front surface (top surface) of the multilayer wiring board. Therefore, the tuner unit is covered with the group of terminals, the shield plate, and the ground layer of the multilayer wiring board, such that favorable shield effect can be expected. In addition in the television receiving tuner, the demodulating unit and the tuner unit are dividedly provided on the front and rear surfaces of the multilayer wiring board, and thus a planar size of the television receiving tuner is suppressed. Besides, a height of the entire television receiving tuner is the sum of a height of the shield plate or the demodulating unit, the height of the shield plate and the height of the demodulating unit may be substantially equal to each other, a thickness of the multilayer wiring board, and a height of the terminal, which may be slightly larger than a height of the tuner unit. Accordingly, it is easy to markedly suppress the height of the entire device. Further, in the television receiving tuner, heat generated from the semiconductor for a high frequency serving as a heat source can be efficiently emitted from the shield plate to the outside through the ground layer, and thus high heat dissipation effect can be realized.

In the above-described configuration, it is preferable that rib-shaped convex portions be formed in the shield plate through concave groove portions, and the concave groove portions be connected to the ground layer on the multilayer wiring board. With this configuration, a surface area of the shield plate is increased, and thus heat dissipation effect can be further increased. In addition, the shield plate having increased mechanical strength by the rib-shaped convex portions is disposed around the demodulating unit, and the concave groove portion between adjacent convex portions is fixed onto the front surface of the multilayer wiring board. Therefore, components are disposed on the front and rear surfaces of the multilayer wiring board in balance, and thus the board can be prevented from being curved.

Further, in the above-described configuration, it is preferable that a buffering member formed of a resin material (for example, silicon resin) having high thermal conductivity be provided between the semiconductor for a high frequency and the mother board. According to this configuration, the semiconductor for a high frequency can be protected from mechanical impacts with the buffering member. Further, since heat of the semiconductor for a high frequency is transferred to the buffering member, heat dissipation effect can be further increased.

### BRIEF DESCRIPTION OF THE DRAWINGS

FIG. 1 is a cross-sectional view schematically showing a television receiving tuner according to an embodiment of the invention;
FIG. 2 is a plan view of the television receiving tuner;
FIG. 3 is a bottom view of the television receiving tuner;
FIG. 4 is a partial perspective view showing a concavo-convex shape of a shield plate included in the television receiving tuner; and
FIG. 5 is a cross-sectional view schematically showing a television receiving tuner according to the related art.

### DESCRIPTION OF THE PREFERRED EMBODIMENT

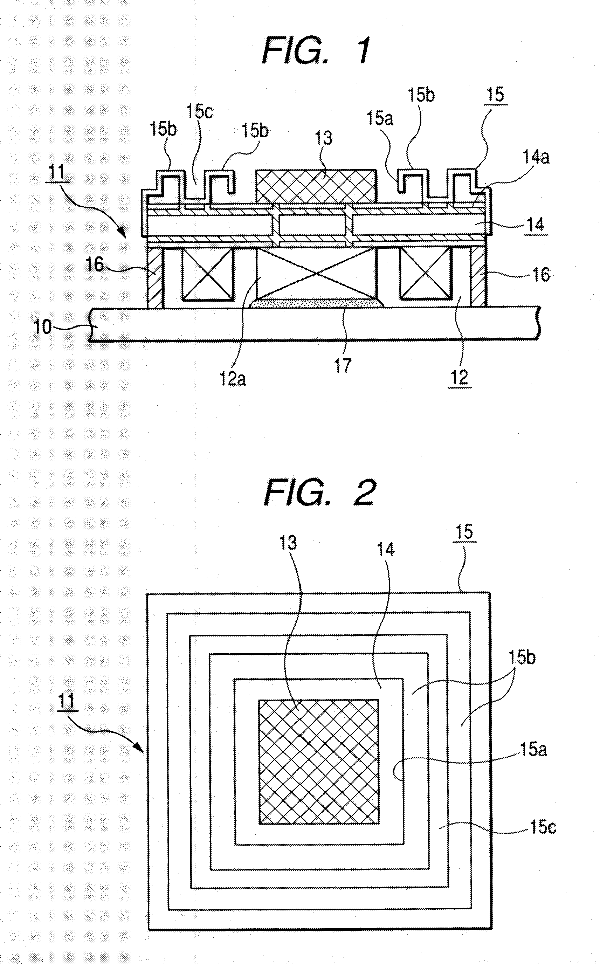

An embodiment of the invention will be described with reference to the drawings. FIG. 1 is a cross-sectional view schematically showing a television receiving tuner according to an embodiment of the invention. FIG. 2 is a plan view of the television receiving tuner. FIG. 3 is a bottom view of the television receiving tuner. FIG. 4 is a partial perspective view showing a concavo-convex shape of a shield plate included in the television receiving tuner.

A television receiving tuner 11 shown in FIGS. 1 to 3 is mounted on a mother board 10, and then is incorporated into a cellular phone. A tuner unit 12 and a demodulating unit 13 are dividedly provided on bottom (rear) and top (front) surfaces of a multilayer wiring board 14, and thus a planar size is suppressed, thereby realizing a reduction in size. Further, in the television receiving tuner 11, a concavo-convex shield plate 15 is provided around the demodulating unit 13 on the top surface of the multilayer wiring board 14, and thus shield effect and heat dissipation effect are increased. In addition, the shield plate 15 is set to have the same height as that of the demodulating unit 13, such that a height of the entire device is suppressed, thereby realizing a reduction in thickness (reduction in height).

That is, the television receiving tuner 11 schematically has the multilayer wiring board 14 that has a ground layer 14a provided inside and outside, the tuner unit 12 that has a semiconductor for a high frequency, such as an IC package 12a or the like, mounted on the bottom surface (the surface facing the mother board 10) of the multilayer wiring board 14 to form a circuit, the demodulating unit 13 that has a semiconductor for an intermediate frequency mounted on the top surface of the multilayer wiring board 14 to form a circuit, the shield plate 15 that is disposed to cover the top surface of the multilayer wiring board 14, excluding an opening 15a for exposing the demodulating unit 13, and a plurality of terminals 16 that are arranged over an outer circumference of the bottom surface of the multilayer wiring board 14. Here, the multilayer wiring board 14, the tuner unit 12, and the demodulating unit 13 have the same basic structures as those in the related art shown in FIG. 5.

The shield plate 15 is formed to have a concavo-convex shape shown in FIG. 4 by performing a pressing process on a metal thin plate. As shown in FIG. 2, at the center of the shield plate 15, the opening 15a for exposing the demodulating unit 13 is formed. Further, a pair of rib-shaped convex portions 15b is formed in the shield plate 15 to surround the opening 15a. As shown in FIG. 1, a bottom surface of a concave groove portion 15c formed between the convex portions 15b is soldered to the ground layer 14a on the multilayer wiring board 14. Moreover, a height of the shield plate 15 (the projection amount of the convex portion 15b) is set to be equal to a height of the demodulating unit 13. In the present embodiment, the height of the demodulating unit 13 and the height of the shield plate 15 are set to about 0.3 mm.

As shown in FIG. 3, the terminals 16 are formed of spherical bump electrodes for flip chip mounting. The terminals 16 are arranged in a box shape at predetermined intervals in the outer circumference of the bottom surface of the multilayer wiring board 14. And then, the terminals 16 are correspondingly soldered to connection lands on the mother board 10, and thus the television receiving tuner 11 is mounted on the mother board 10. At this time, the tuner unit 12 or the demodulating unit 13 transmits and receives electrical signals to and from an external circuit (not shown) through some of the terminals 16. Moreover, the multilayer wiring board 14 is supported on the mother board 10 by the group of terminals 16. In the present embodiment, a height of each terminal 16 is set to about 0.65 mm, which is slightly larger than the height of the tuner unit 12 (about 0.6 mm).

Further, in the television receiving tuner 11, a buffering member 17, formed of silicon resin having high thermal conductivity or the like, is provided in a gap between the IC package 12a of the tuner unit 12 and the mother board 10. That is, the IC package 12a is interposed between the multilayer wiring board 14 and the buffering member 17.

In the television receiving tuner 11 according to the present embodiment, on the mother board 10, the tuner unit 12 is provided on the bottom surface of the multilayer wiring board 14, and the tuner unit 12 is surrounded by the group of terminals 16. Further, the top surface of the multilayer wiring board 14 is widely covered with the shield plate 15. Therefore, the tuner unit 12 is covered with the group of terminals 16, the shield plate 15, and the ground layer 14a of the multilayer wiring board 14. For this reason, the television receiving tuner 11 has high shield effect on the tuner unit 12, and noise caused by external waves rarely has a bad influence on the tuner unit 12.

Further, in the television receiving tuner 11, in order to suppress the planar size, the demodulating unit 13 and the tuner unit 12 are dividedly provided on the front and rear surfaces of the multilayer wiring board 14. However, unlike the example of the related art shown in Fig. 5, the demodulating unit 13 is provided on the top surface of the multilayer wiring board 14. Therefore, a necessary height above the multilayer wiring board 14 is such a small space that the demodulating unit 13 and the shield plate 15 can be disposed. As a result, the height of the entire device can be markedly reduced. Specifically, the height of the entire television receiving tuner 11 is the sum (about 1.45 mm) of the height of the demodulating unit 13 or the shield plate 15 (about 0.3 mm), the thickness of the multilayer wiring board 14 (about 0.5 mm), and the height of the terminal 16 (about 0.65 mm). Therefore, a height of 1.5 mm or less, which is necessary to incorporate into a recent cellular phone, can be realized.

Further, in the television receiving tuner 11, heat generated from the semiconductor for a high frequency, such as the IC package 12a or the like, may be transferred to the shield plate 15 through the ground layer 14a. In this case, however, the shield plate 15 is formed in a concavo-convex shape to function as a heat sink having a large surface area, and thus favorable heat dissipation effect can be expected. In addition, the shield plate 15 has increased mechanical strength due to the rip-shaped convex portions 15b. And then, in a state in which the shield plate 15 having sufficient mechanical strength is disposed around the demodulating unit 13, the concave groove portion 15c between adjacent convex portions 15b is fixed onto the top surface of the multilayer wiring board 14. Therefore, components can be provided on the front and rear surfaces of the multilayer wiring board 14 in balance, and thus the multilayer wiring board 14 can be prevented from being curved.

Further, in the television receiving tuner 11, the buffering member 17, formed of silicon resin or the like, is disposed between the IC package 12a and the mother board 10. Therefore, the IC package 12a can be protected from mechanical impacts with the buffering member 17, and thus reliability can be increased. Besides, some of heat generated from the IC package 12a serving as the heat source can be transferred to the buffering member 17 to be emitted, and thus the buffering member 17 contributes to the enhancement of heat dissipation effect.

Moreover, in the above-described embodiment, a case in which the television receiving tuner according to the invention is incorporated into the cellular phone has been described. Of course, even when the television receiving tuner is incorporated into a small electronic apparatus, other than the cellular phone, the same effects can be obtained.

In the television receiving tuner according to the aspect of the invention, the tuner unit provided on the rear surface of the multilayer wiring board is surrounded by the group of terminals on the mother board. Further, the shield plate is disposed around the demodulating unit on the front surface of the multilayer wiring board. Therefore, the tuner unit is covered with the group of terminals, the shield plate, and the ground layer of the multilayer wiring board, such that favorable shield effect can be expected. Further, in the television receiving tuner, since the demodulating unit and the tuner unit are dividedly provided on the front and rear surfaces of the multilayer wiring board, the planar size can be suppressed. In addition, since a necessary height above the multilayer wiring board is such that the demodulating unit or the shield plate can be disposed, the height of the entire device can be markedly suppressed, and thus a reduction in size and thickness can be realized. Further, heat generated from the semiconductor for a high frequency serving as the heat source can be efficiently emitted from the shield plate to the outside through the ground layer, and thus high heat dissipation effect can be realized.

## Claims

1. A television receiving tuner comprising:
a multilayer wiring board that has a ground layer provided inside and outside;
a demodulating unit that has a semiconductor for an intermediate frequency mounted on a front surface of the multilayer wiring board to form a circuit;
a metal shield plate that is mounted on the front surface of the multilayer wiring board so as to surround the demodulating unit and is connected to the ground layer;
a tuner unit that has a semiconductor for a high frequency mounted on a rear surface of the multilayer wiring board to form a circuit; and
a group of terminals that is provided in parallel over an outer circumference of the rear surface of the multilayer wiring board to be connected to a mother board,
wherein, on the multilayer wiring board, a height of the shield plate is set to be substantially equal to a height of the demodulating unit, and the group of terminals is connected to the ground layer.

2. The television receiving tuner according to claim 1,
wherein rib-shaped convex portions are formed in the shield plate through concave groove portions, and the concave groove portions are connected to the ground layer on the multilayer wiring board.

3. The television receiving tuner according to claim 1,
wherein a buffering member formed of a resin material having high thermal conductivity is provided between the semiconductor for a high frequency and the mother board.
